# EUROPEAN PATENT SPECIFICATION

(11) **EP 4 257 943 B1**
(45) Date of publication and mention of the grant of the patent: **20.11.2024**
(21) Application number: 23164677.9
(22) Date of filing: 28.03.2023
(51) Int. Cl.: G01K 1/14, G01K 1/02, H01L 23/34, H01L 25/18, H01L 23/538, H01L 23/053, H01L 23/373, H01L 23/498, H01L 23/24, H01L 25/07

(54) **TEMPERATURE SENSOR ARRANGEMENT IN SEMICONDUCTOR MODULE**
TEMPERATURSENSORANORDNUNG IN EINEM HALBLEITERMODUL
AGENCEMENT DE CAPTEUR DE TEMPÉRATURE DANS UN MODULE SEMI-CONDUCTEUR

(30) Priority: 06.04.2022 US 202217714550
(43) Date of publication of application: 11.10.2023
(73) Proprietor: Infineon Technologies AG, 85579 Neubiberg (DE)
(72) Inventor: ARENS, Andre, 59602 Ruethen (DE); EBLI, Michael, 71116 Gärtringen (DE)
(74) Representative: Westphal, Mussgnug & Partner, Patentanwälte mbB

(56) References cited:
- WO-A1-2018/016162
- WO-A1-2021/151949
- US-A1- 2020 321 262
- US-A1- 2022 093 486

## Description

### BACKGROUND

Many different applications such as automotive and industrial applications utilize power modules. Power modules may include multiple power devices in a single packaged device, with these power devices being configured as a power conversion circuit such as a single and multi-phase half-wave rectifier, single and multi-phase full-wave rectifier, voltage regulator, inverter, etc. Modern power modules are designed for highly efficient operation and can improve the electric power dissipation of an electrical system. Document WO 2021/151949 A1 discloses a power semiconductor module, comprising: a substrate with a metallization layer, which is structured; at least one semiconductor chip bonded to the metallization layer with a first side; a metal clip, which is a strip of metal, bonded with a first planar part to a second side of the semiconductor chip opposite to the first side and bonded with a second planar part to the metallization layer; a mold encapsulation at least partially enclosing the substrate, the at least one semiconductor chip and the metal clip, the mold encapsulation having a recess approaching towards the first planar part of the metal clip; a circuit board attached to the mold encapsulation above the recess; wherein the semiconductor chip, to which the metal clip is bonded, is completely enclosed by the mold encapsulation, the substrate and the metal clip; wherein the first planar part of the metal clip is at least partially exposed by the recess; wherein the circuit board carries a sensor accommodated in the recess.

Document US 2020/321262 A1 discloses a power semiconductor module including a power semiconductor chip arranged between a first substrate and a second substrate and electrically coupled to the substrates, and a temperature sensor arranged between the substrates and laterally besides the power semiconductor chip such that a first side of the temperature sensor faces the first substrate and a second side of the temperature sensor faces the second substrate. A first electrical contact of the temperature sensor is arranged on the first side and electrically coupled to the first substrate. A second electrical contact of the temperature sensor is arranged on the second side and electrically coupled to the second substrate.

Document WO 2018/016162 A1 discloses a semiconductor device provided with first and second substrates. The first and second substrates are facing each other by having a predetermined gap therebetween. A plurality of semiconductor elements are mounted on a first substrate surface facing the second substrate. A plurality of temperature detection elements are mounted on a second substrate surface facing the first substrate, and are thermally in contact with the semiconductor elements.

Document US 2022/093486 A1 discloses a power semiconductor module including: a carrier; a plurality of semiconductor dies attached to a first side of the carrier and electrically connected to form a circuit or part of a circuit; a cooling device at a second side of the carrier opposite the first side; a clamping device attached to the cooling device and pressing the carrier toward the cooling device such that the second side of the carrier is in thermal contact with the cooling device without having an intervening base plate between the carrier and the cooling device; and a first sensor device embedded in the clamping device or attached to an interior surface of the clamping device.

Power modules include elements that generate a substantial amount of heat during operation. For example, power semiconductor transistor dies may operate at temperatures of at least 100°C, 150°C, 200°C or more. Other components power modules such as passive elements may also operate at these high temperatures during operation. It may be beneficial to incorporate temperature monitoring functionality into a power module that measures the temperature of the heat generating elements. Temperature monitoring can be used to prevent acute device failure and/or preserve the useful life of a power module. Current temperature sensing solutions in power modules suffer from drawbacks including increased area requirements, cost, complexity, and inaccuracy.

Thus, there is a need for improved temperature monitoring solutions in electronics applications such as power module applications.

### SUMMARY

A semiconductor module is disclosed. According to an embodiment, the semiconductor module comprises a first circuit carrier comprising one or more heat generating elements mounted on an upper surface of the first circuit carrier, a second circuit carrier mounted over the first circuit carrier and being vertically spaced apart from the upper surface of the first circuit carrier, a temperature sensor that is fixedly attached to the second circuit carrier and is arranged in a vertical space between the lower surface of the second circuit carrier and the upper surface of the first circuit carrier, and a plurality of elements extending from the upper surface of the first circuit carrier towards the second circuit carrier, and supporting the second circuit carrier, wherein the temperature sensor is arranged in sufficient proximity to a first one of the heat generating elements to obtain a direct temperature measurement from the first one of the heat generating elements, and wherein the semiconductor module further comprises a dielectric material that fills a space between the temperature sensor and the first one of the heat generating elements, wherein the dielectric material is a potting compound that encapsulates each of the one or more heat generating elements.

A method of operating a semiconductor module is disclosed. According to an embodiment, the method comprises providing a semiconductor module comprising a first circuit carrier comprising one or more heat generating elements mounted on an upper surface of the first circuit carrier; a second circuit carrier mounted over the first circuit carrier and being vertically spaced apart from the upper surface of the first circuit carrier; one or more temperature sensors that are fixedly attached to the second circuit carrier and arranged in a vertical space between the lower surface of the second circuit carrier and the upper surface of the first circuit carrier; a plurality of elements extending from the upper surface of the first circuit carrier towards the second circuit carrier, and supporting the second circuit carrier; and a dielectric material that fills a space between the temperature sensor and the first one of the heat generating elements, wherein the dielectric material is a potting compound that encapsulates each of the one or more heat generating elements; and obtaining a direct temperature measurement of a first one of the heat generating elements using a first one of the temperature sensors.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1 illustrates a semiconductor module comprising a temperature sensor that is disposed over a heat generating element, according to an embodiment.
Figure 2 illustrates a semiconductor module comprising a temperature sensor that is disposed over a heat generating element, according to another embodiment.

### DETAILED DESCRIPTION

Embodiments of a semiconductor module with an advantageous temperature monitoring arrangement are described herein. The semiconductor module comprises a stacked arrangement of circuit carriers, with a lower circuit carrier and an upper circuit carrier that is mounted over and vertically spaced apart from the lower circuit carrier. The heat generating elements of the semiconductor module, including power semiconductor dies and passive elements, are mounted on the lower circuit carrier. Meanwhile, the upper circuit carrier accommodates the mounting of one or more temperature sensors that are positioned to measure a temperature of the heat generating elements. The temperature sensors can be configured to perform a direct temperature measurement of the heat generating elements. The upper circuit carrier can accommodate a controller element that receives and processes the temperature measurement temperature sensors. This arrangement eliminates the need for other types of temperature sensing elements, such as temperature sensing diodes, shunt elements, and integrated temperature sensing circuitry on the lower circuit carrier, and thus reduces size and cost of the semiconductor module in comparison to these module configurations.

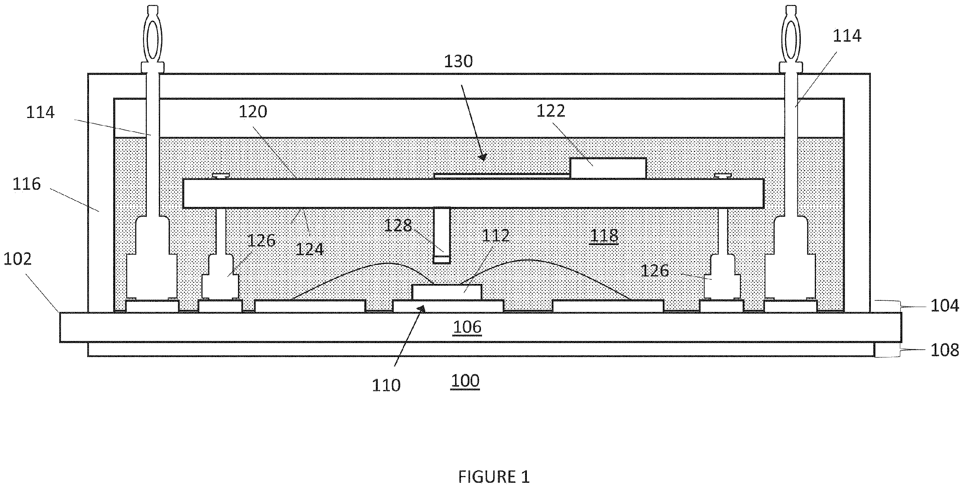

Referring to Figure 1, a semiconductor module 100 comprises a first circuit carrier 102. The first circuit carrier 102 comprises a structured metallization layer 104 disposed on an electrically insulating substrate 106. The structured metallization layer 104 comprises a plurality of pads that are electrically isolated from one another. The pads are dimensioned to accommodate the mounting of semiconductor dies or passive elements thereon. Additionally, the pads can form part of an electrical interconnect structure that connects two or more devices together. The first circuit carrier 102 may additionally comprise a second metallization layer 108 disposed on a rear side of the first circuit carrier 102. The second metallization layer 108 may be a continuous layer that is used to thermally couple the semiconductor module 100 to a cooling apparatus, such as a heat sink. The first structured metallization layer 104 and the second metallization layer 108 may comprise or be plated with any or more of Cu, Ni, Ag, Au, Pd, Pt, NiV, NiP, NiNiP, NiP/Pd, Ni/Au, NiP/Pd/Au, or NiP/Pd/AuAg.

According to an embodiment, the first circuit carrier 102 is a power electronics substrate. For example, the first circuit carrier 102 may be a Direct Copper Bonding (DCB) substrate, a Direct Aluminum Bonding (DAB) substrate, an Active Metal Brazing (AMB) substrate, or an Insulated Metal Substrate (IMS). In a power electronics substrate, the electrically insulating substrate 106 may comprise ceramic material such as Al₂O₃ (Alumina) AIN (Aluminum Nitride), etc., or may comprise filled materials such as epoxy resin or polyimide, e.g., in the case of an IMS. Alternatively, the first circuit carrier 102 may be a printed circuit board (PCB). In that case, the electrically insulating substrate 106 may comprise a resin or epoxy resin material such as FR-4.

One or more heat generating elements 110 are mounted on an upper surface of the first circuit carrier 102. As shown, the heat generating elements 110 mounted on the first circuit carrier 102 comprise a semiconductor die 112. More generally, the heat generating elements 110 can comprise any electrical element that generates heat by electrical current flowing through the element. Examples of heat generating elements 110 include active devices, e.g., discrete transistor dies, controllers, etc., passive devices, e.g., discrete diodes, capacitors, inductors, etc., and electrical interconnect elements, e.g., metal clips, bond wires, ribbons, etc.

The semiconductor die 112 may be a power transistor die, such as a thyristor, diode, MOSFET or IGBT. In an embodiment, the semiconductor module 100 is configured as a power module, wherein the semiconductor die 112 is a power transistor die that is configured to conduct a load voltage of the power converter circuit, such as a high-side switch or a low-side switch of a half-bridge circuit. The power module may additionally comprise other devices such as driver dies that control a switching operation of the half-bridge circuit mounted on an upper surface of the first circuit carrier 102.

The semiconductor module 100 comprises terminal connectors 114 extending from the first circuit carrier 102 to an externally accessible location. The terminal connectors 114 may be soldered to or otherwise attached to the first circuit carrier 102. The terminal connectors 114 may be electrically conductive structures formed from, e.g., copper, aluminum, alloys thereof, etc. The terminal connectors 114 form external points of electrical contact to the devices mounted on the carrier. As shown, the terminal connectors 114 are configured as press-fit connectors that are designed to form a forcefitting connection with an external device, such as a PCB socket. More generally, these terminal connectors 114 may have a variety of different configurations and may be adapted to mate with a particular receptacle design, e.g., through force fitting or soldered connections.

The semiconductor module 100 comprises a housing 116 that surrounds an interior volume over the first circuit carrier 102. The housing 116 in combination with the first circuit carrier 102 may form an enclosure. To this end, the housing 116 comprises sidewalls that are affixed to and/or in contact with the first circuit carrier 102 and a cover section extending over the interior volume. The housing 116 may be formed from a plastic material, for example.

The semiconductor module 100 comprises an encapsulant material 118 that fills the interior volume defined by the housing 116 and the first circuit carrier 102. The encapsulant material 118 protects the components arranged inside the housing 116 and in particular encapsulates the semiconductor die 112 and associated electrical connection elements, thereby protecting these elements from environmental conditions and mechanical breakage. Generally speaking, the encapsulant can comprise any of a wide variety of materials that are used in electronics applications to protect semiconductor dies. The encapsulant may be a dielectric material that electrically isolates the components from one another. According to an embodiment, the encapsulant material 118 is a curable encapsulant material, such as a dielectric gel. More particularly, the encapsulant material 118 may be potting compound, such as a silicone-based potting compound.

The semiconductor module 100 comprises a second circuit carrier 120 arranged within the interior volume. The second circuit carrier 120 is mounted over the first circuit carrier 102 such that a lower surface 124 of the second circuit carrier 120 is vertically spaced apart from the upper surface of the first circuit carrier 102. The upper surface of the first circuit carrier 102 refers to the surface of the structured metallization layer 104 that faces the second circuit carrier 120 or the surface of the electrically insulating substrate 106 that is exposed from the structured metallization layer 104. Thus, a three-dimensional volume exists between the first circuit carrier 102 and the second circuit carrier 120. The semiconductor module 100 may comprise support structures 126 that facilitate the arrangement of the second circuit carrier 120. The support structures 126 may be similar structures as the previously described terminal connectors 114, e.g., metal posts comprising copper, aluminum, etc. and may be affixed to the structured metallization layer 104 by an adhesive, e.g., solder, sinter, glue, etc. As shown, the semiconductor module 100 comprises dedicated support structures 126 that are separate from the terminal connectors 114. Alternatively, the support structures 126 can be part of the terminal connectors 114, and the second circuit carrier 120 can form electrical connections thereto (if desired) or can be electrically isolated from these support structures 126 (if desired). In still other embodiments, the second circuit carrier 120 is supported by an element that is attached to the electrically insulating substrate 106 of the first circuit carrier 102 and/or to the housing 116.

According to an embodiment, the second circuit carrier 120 is a printed circuit board (PCB). In combination, the first circuit carrier 102 may be a power electronics substrate, e.g., DCB substrate, DAB substrate, AMB substrate, or an IMS substrate. In this way, the second circuit carrier 120 can be a relatively less expensive component than a power electronics substrate without any detrimental impact in performance, as any elements mounted on the second circuit carrier 120, such as the controller 122 to be described in further detail below, do not require the electrical and heat performance properties of a power electronics substrate. Meanwhile, the heat generating elements 110 that generate significant amounts of heat during operation are mounted on a power electronics substrate that is well-suited for heat extraction and electrical isolation of these components. Alternatively, the second circuit carrier 120 may be a power electronics substrate such as a DCB, substrate, DAB substrate, AMB substrate, an IMS substrate or other type of electronics carrier, e.g., if needed to meet performance requirements.

The semiconductor module 100 further comprises a temperature sensor 128. The temperature sensor 128 is arranged in the vertical space between the lower surface 124 of the second circuit carrier 120 and the upper surface of the first circuit carrier 102. The temperature sensor 128 is fixedly attached to the second circuit carrier 120. This attachment may be done by a fastening mechanism, e.g., screw, bolt, etc., or by an adhesive, for example. Separately or in combination, the temperature sensor 128 may comprise leads that are inserted into and retained by the second circuit carrier 120.

The temperature sensor 128 can be any sensory device that is configured to perform a direct temperature measurement. In this context, a direct temperature measurement refers to a measurement of the temperature of the heat generating element 110 itself or the temperature of surrounding material or environment of the heat generating element 110. By contrast, an indirect temperature measurement is a measurement of some other operating parameter of the heat generating element 110 besides temperature, e.g., current, magnetic field, voltage, etc., that is used to extrapolate the temperature of the heat generating element 110 according to a known relationship. Examples temperature sensor 128 embodiments that can configured to perform a direct temperature measurement include semiconductor-based temperature sensors, including analog and digital temperature sensors, thermistors, thermocouples, resistance temperature detectors and infrared-temperature sensors

The temperature sensor 128 is arranged in sufficient proximity to a first one of the heat generating elements 110 mounted on the first circuit carrier 102 to obtain a direct temperature measurement of the first one of the heat generating elements 110. In the embodiment of Fig. 1, the semiconductor die 112 corresponds to the first one of the heat generating elements 110 that is in sufficient proximity to the temperature sensor 128. The proximity necessary to obtain a direct temperature is dependent upon a variety of factors, such as the type of temperature sensor 128, type of heat generating element 110, and medium between the temperature sensor 128 and heat generating elements 110. Generally speaking, the temperature sensor 128 can be disposed at a distance of between 0.1 mm and 2.0 mm, with respect to required electrical isolation distances between the surface of 112 and the temperature sensor 128, from the heat generating element 110 to obtain a direct temperature measurement. In the depicted embodiment, the temperature sensor 128 is disposed directly over the semiconductor die 112. While this arrangement may be advantageously space efficient, it is not necessary. In other embodiments, the temperature sensor 128 can be laterally offset from the heat generating element 110 to which it is assigned to obtain a direct measurement from. In the case of an infrared based measurement sensor device, the temperature sensor 128 may be arranged to be in direct line of sight with the heat generating element 110. Otherwise, line of sight may not be necessary.

According to an embodiment, the temperature sensor 128 is galvanically isolated from the first one of the heat generating elements 110. That is, the electrical currents and associated magnetic fields that exist in the first one of the heat generating elements 110 do not influence the operation of the temperature sensor 128 and vice-versa. Galvanic isolation may result from a dielectric medium, which may include ambient air, a dielectric compound, or both. As shown, the encapsulant material 118 serves a dual role as encapsulant that protects the devices mounted on the first circuit carrier 102 and as a dielectric medium that fills the space between the temperature sensor 128 and the semiconductor die 112. Thus, the material for the encapsulant material 118 and the spacing between the temperature sensor 128 and the first one of the heat generating elements 110 may be selected to ensure proper electrical isolation.

The semiconductor module 100 may comprise a controller 122 mounted on an upper surface of the second circuit carrier 120. The controller 122 receives a measurement signal from the temperature sensor 128 and determines a temperature of the first one of the heat generating elements 110 based on the temperature signal. For example, the controller 122 can receive a digital output from the temperature sensor 128, e.g., in the case of a digital device or analog signal, e.g., current, frequency, etc., e.g., in the case of a thermistors, thermocouple, resistance temperature detector, etc. The signal can be transmitted between the controller 122 and the temperature sensor 128 by a signal connection 130, which may comprise a combination of conductive traces in the second circuit carrier 120 and interconnect elements. The controller 122 can be a logic device such as an ASIC (application specific integrated circuit), FPGA (field gate programmable array), etc., that is configured to perform some action based on the ascertained temperature signal. For example, the controller 122 may be used to turn off or adjust the operation of the elements mounted on the first circuit carrier 102, including the first one of the heat generating elements 110.

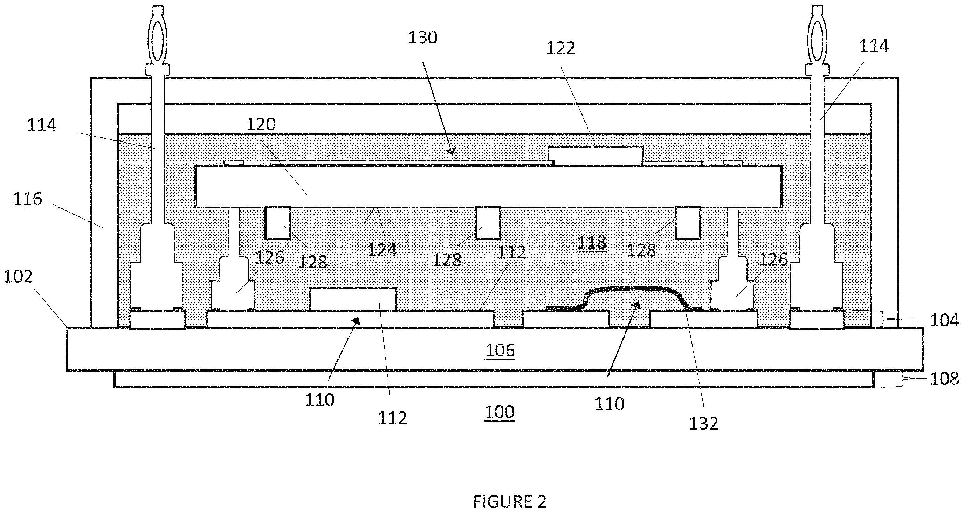

Referring to Figure 2, a semiconductor module 100 is shown, according to another embodiment. In this embodiment, the semiconductor module 100 comprises a plurality of the temperature sensors 128 fixedly attached to the second circuit carrier 120 and arranged in the vertical space between the lower surface 124 of the second circuit carrier and the upper surface of the first circuit carrier 102. Each of the temperature sensors 128 in the plurality can have any of the above-described configurations.

According to an embodiment, each of the temperature sensors 128 in the plurality are digital temperature sensors. The controller 122 can receive a measurement signal from each of the temperature sensors 128 and therefore ascertain a temperature measurement at different locations of the semiconductor module 100. According to one concept, the temperature sensors 128 and the controller 122 are arranged to perform a sequential measurement wherein the controller 122. The controller 122 can read each one of the temperatures sequentially, i.e., receives a measurement from each one of the temperature sensors 128 according to a periodic or predictable sequence.

Additionally, the semiconductor module 100 comprises plurality of the heat generating elements 110 mounted on the upper surface of the first circuit carrier 102. As shown, the plurality of the heat generating elements 110 comprises a first one of the heat generating elements 110 and a second one of the heat generating elements 110, wherein the first one of the heat generating elements 110 corresponds to the semiconductor die 112 and the second one of the heat generating elements 110 is a passive element 132. More particularly, the second one of the heat generating elements 110 is a shunt resistor that is connected between to separate pads of the structured metallization layer 104. The shunt resistor may be configured to sense a current of the semiconductor module 100, such as a current flowing through the switching device of a power converter or power inverter circuit.

The temperature sensors 128 may be arranged to be in sufficient proximity to obtain a direct temperature measurement from more than one of the heat generating elements 110. For example, as shown, a first centrally located one of the temperature sensors 128 is arranged laterally in between the first and second ones of the heat generating elements 110, i.e., the semiconductor die 112 and the passive element 132. The first centrally located one of the temperature sensors 128 may be in sufficient proximity to obtain a direct temperature measurement from the semiconductor die 112 and the passive element 132. The measurement information received from the first centrally located one of the temperature sensors 128 may be processed in combination with the measurement information received from the other temperature sensors 128 arranged on either side of the semiconductor die 112 and the passive element 132 to obtain a differential temperature reading that can be processed by the controller 122. More generally, the controller 122 can determine a temperature of each of the heat generating elements 110 based on the signals from each of the temperature sensors 128, by performing a differential analysis as described above or by direct measurement from a temperature sensor 128 that is dedicated to a particular heat generating element 110. For example, the number of temperature sensors 128 may be less than the number of heat generating elements 110, wherein the above-described concept is used to perform a temperature measurement for at least some of the heat generating elements 110. Alternatively, the same number or a greater number of temperature sensors 128 than the heat generating elements 110 may be provided, e.g., for greater accuracy.

A power semiconductor die refers to a single die that is rated to accommodate voltages of at least 100 V (volts), and more typically voltages of 600 V, 1200 V or more and/or is rated to accommodate currents of at least 1A, and more typically currents of 10A, 50A, 100A or more. Examples of power semiconductor dies include discrete power diodes and discrete power transistor dies, e.g., MOSFETs (Metal Oxide Semiconductor Field Effect Transistors), IGBTs (Insulated Gate Bipolar Transistors), and HEMTs (High Electron Mobility Transistors), etc. At least one of the heat generating elements 110 may comprise.

The semiconductor dies disclosed herein can be formed in a wide variety of device technologies that utilize a wide variety of semiconductor materials. Examples of such materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AllnN), indium gallium nitride (InGaN), aluminum gallium indium nitride (AIGalnN) or indium gallium arsenide phosphide (InGaAsP), etc.

The semiconductor dies disclosed herein may be configured as a vertical device, which refers to a device that conducts a load current between opposite facing main and rear surfaces of the die. Alternatively, the semiconductor dies may be configured as a lateral device, which refers to a device that conducts a load current parallel to a main surface of the die.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

## Claims

1. A semiconductor module (100), comprising:
a first circuit carrier (102) comprising one or more heat generating elements (110) mounted on an upper surface of the first circuit carrier (102);
a second circuit carrier (120) mounted over the first circuit carrier (102) and being vertically spaced apart from the upper surface of the first circuit carrier (102);
a temperature sensor (128) that is fixedly attached to the second circuit carrier (120) and is arranged in a vertical space between the lower surface of the second circuit carrier (120) and the upper surface of the first circuit carrier (102); and
a plurality of elements (114, 126) extending from the upper surface of the first circuit carrier (102) towards the second circuit carrier (120), and supporting the second circuit carrier (120),
wherein the temperature sensor (128) is arranged in sufficient proximity to a first one of the heat generating elements (110) to obtain a direct temperature measurement from the first one of the heat generating elements (110), and
wherein the semiconductor module (100) further comprises a dielectric material (118) that fills a space between the temperature sensor (128) and the first one of the heat generating elements (110), wherein the dielectric material (118) is a potting compound that encapsulates each of the one or more heat generating elements (110).

2. The semiconductor module (100) of claim 1, wherein the temperature sensor (128) is galvanically isolated from the first one of the heat generating elements (110).

3. The semiconductor module (100) of claim 1 or 2, wherein
the first one of the heat generating elements (110) is a power semiconductor die, or
the first one of the heat generating elements (110) is a passive element.

4. The semiconductor module (100) of any of claims 1 to 3, wherein the temperature sensor (128) is arranged directly over the first one of the heat generating elements (110).

5. The semiconductor module (100) of any of claims 1 to 4, wherein the one or more heat generating elements (110) comprise a second one of the heat generating elements (110), wherein the temperature sensor (128) is arranged laterally in between the first and second ones of the heat generating elements (110), and wherein the temperature sensor (128) is arranged in sufficient proximity to the second one of the heat generating elements (110) to obtain a direct temperature measurement from the second one of the heat generating elements (110).

6. The semiconductor module (100) of any of claims 1 to 5, further comprising a controller (122) mounted on an upper surface of the second circuit carrier (120), wherein the controller (122) is configured to receive a measurement signal from the temperature sensor (128) by and determine a temperature of the first one of the heat generating elements (110) based on the measurement signal.

7. The semiconductor module (100) of claim 6, wherein the semiconductor module (100) comprises a plurality of the temperature sensors (128) fixedly attached to the second circuit carrier (120) and arranged in the vertical space between the lower surface of the second circuit carrier (120) and the upper surface of the first circuit carrier (102), wherein the controller (122) is configured to receive signals from each of the temperature sensors (128) and determine a temperature of at least the first one of the heat generating elements (110) based on the signals.

8. The semiconductor module (100) of claim 7, wherein the semiconductor module (100) comprises a plurality of the heat generating elements (110), wherein the controller (122) is configured to determine a temperature each of the heat generating elements (110) based on the signals, and wherein the temperature sensors (128) in the plurality outnumber all of the heat generating elements (110) mounted on the first circuit carrier (102).

9. The semiconductor module (100) of any of claims 1 to 8, wherein at least one of
the first circuit carrier (102) is any one of: a DCB substrate, an AMS substrate, an AMB substrate, or an IMS substrate, and
the second circuit carrier (120) is a printed circuit board.

10. A method of operating a semiconductor module (100), the method comprising:
providing a semiconductor module (100) comprising a first circuit carrier (102) comprising one or more heat generating elements (110) mounted on an upper surface of the first circuit carrier (102); a second circuit carrier (120) mounted over the first circuit carrier (102) and being vertically spaced apart from the upper surface of the first circuit carrier (102); one or more temperature sensors (128) that are fixedly attached to the second circuit carrier (120) and arranged in a vertical space between the lower surface of the second circuit carrier (120) and the upper surface of the first circuit carrier (102); a plurality of elements (114, 126) extending from the upper surface of the first circuit carrier (102) towards the second circuit carrier (120), and supporting the second circuit carrier (120); and a dielectric material (118) that fills a space between the temperature sensor (128) and the first one of the heat generating elements (110), wherein the dielectric material (118) is a potting compound that encapsulates each of the one or more heat generating elements (110); and
obtaining a direct temperature measurement of a first one of the heat generating elements (110) using a first one of the temperature sensors (128).

11. The method of claim 10, wherein the semiconductor module (100) comprises a controller (122) mounted on an upper surface of the second circuit carrier (120), and wherein the method further comprises transmitting the direct temperature measurement to the controller (122) via a signal connection.

12. The method of claim 11, wherein the first circuit carrier (102) comprises a plurality of the heat generating elements (110), wherein the second circuit carrier (120) comprises a plurality of the temperature sensors (128), and wherein the method comprises obtaining a direct temperature measurement from each one of the heat generating elements (110) using each one of the temperature sensors (128) and reading the direct temperature measurements sequentially in the controller (122).

13. The method of any of claims 10 to 12, wherein obtaining the direct temperature measurement comprises an infrared measurement.

## Patentansprüche

1. Halbleitermodul (100), umfassend:
einen ersten Schaltungsträger (102), der eines oder mehrere wärmeerzeugende Elemente (110) umfasst, die auf einer Oberseite des ersten Schaltungsträgers (102) montiert sind;
einen zweiten Schaltungsträger (120), der über dem ersten Schaltungsträger (102) montiert ist und vertikal von der Oberseite des ersten Schaltungsträgers (102) beabstandet ist;
einen Temperatursensor (128), der fest an dem zweiten Schaltungsträger (120) angebracht ist und in einem vertikalen Raum zwischen der Unterseite des zweiten Schaltungsträgers (120) und der Oberseite des ersten Schaltungsträgers (102) angeordnet ist; und
eine Mehrzahl von Elementen (114, 126), die sich von der Oberseite des ersten Schaltungsträgers (102) in Richtung des zweiten Schaltungsträgers (120) erstrecken und den zweiten Schaltungsträger (120) stützen,
wobei der Temperatursensor (128) in ausreichender Nähe zu einem ersten der wärmeerzeugenden Elemente (110) angeordnet ist, um eine direkte Temperaturmessung von dem ersten der wärmeerzeugenden Elemente (110) zu erhalten, und
wobei das Halbleitermodul (100) ferner dielektrisches Material (118) umfasst, das einen Raum zwischen dem Temperatursensor (128) und dem ersten der wärmeerzeugenden Elemente (110) ausfüllt, wobei das dielektrische Material (118) eine Vergussmasse ist, die jedes der einen oder mehreren wärmeerzeugenden Elemente (110) einkapselt.

2. Halbleitermodul (100) nach Anspruch 1, wobei der Temperatursensor (128) galvanisch von dem ersten der wärmeerzeugenden Elemente (110) isoliert ist.

3. Halbleitermodul (100) nach Anspruch 1 oder 2, wobei
das erste der wärmeerzeugenden Elemente (110) ein Leistungshalbleiterchip ist, oder
das erste der wärmeerzeugenden Elemente (110) ein passives Element ist.

4. Halbleitermodul (100) nach einem der Ansprüche 1 bis 3, wobei der Temperatursensor (128) direkt über dem ersten der wärmeerzeugenden Elemente (110) angeordnet ist.

5. Halbleitermodul (100) nach einem der Ansprüche 1 bis 4, wobei das eine oder die mehreren wärmeerzeugenden Elemente (110) ein zweites der wärmeerzeugenden Elemente (110) umfassen, wobei der Temperatursensor (128) seitlich zwischen dem ersten und dem zweiten der wärmeerzeugenden Elemente (110) angeordnet ist, und wobei der Temperatursensor (128) in ausreichender Nähe zu dem zweiten der wärmeerzeugenden Elemente (110) angeordnet ist, um eine direkte Temperaturmessung von dem zweiten der wärmeerzeugenden Elemente (110) zu erhalten.

6. Halbleitermodul (100) nach einem der Ansprüche 1 bis 5, ferner umfassend einen Controller (122) umfasst, der auf einer Oberseite des zweiten Schaltungsträgers (120) montiert ist, wobei der Controller (122) dazu gestaltet ist, ein Messsignal von dem Temperatursensor (128) zu empfangen und eine Temperatur des ersten der wärmeerzeugenden Elemente (110) basierend auf dem Messsignal zu bestimmen.

7. Halbleitermodul (100) nach Anspruch 6, wobei das Halbleitermodul (100) eine Mehrzahl von Temperatursensoren (128) umfasst, die fest mit dem zweiten Schaltungsträger (120) verbunden sind und im vertikalen Raum zwischen der Unterseite des zweiten Schaltungsträgers (120) und der Oberseite des ersten Schaltungsträgers (102) angeordnet sind, wobei der Controller (122) dazu gestaltet ist, Signale von jedem der Temperatursensoren (128) zu empfangen und basierend auf den Signalen eine Temperatur von mindestens dem ersten der wärmeerzeugenden Elemente (110) zu bestimmen.

8. Halbleitermodul (100) nach Anspruch 7, wobei das Halbleitermodul (100) eine Mehrzahl von wärmeerzeugenden Elementen (110) umfasst, wobei der Controller (122) dazu gestaltet ist, basierend auf den Signalen eine Temperatur jedes der wärmeerzeugenden Elemente (110) zu bestimmen, und wobei die Anzahl der Temperatursensoren (128) in der Mehrzahl größer ist als die Anzahl aller wärmeerzeugenden Elemente (110), die auf dem ersten Schaltungsträger (102) montiert sind.

9. Halbleitermodul (100) nach einem der Ansprüche 1 bis 8, wobei mindestens einer der ersten Schaltungsträger (102) ein DCB-Substrat, ein AMS-Substrat, ein AMB-Substrat oder ein IMS-Substrat ist und
der zweite Schaltungsträger (120) eine Leiterplatte ist.

10. Verfahren zum Betreiben eines Halbleitermoduls (100), wobei das Verfahren umfasst:
Bereitstellen eines Halbleitermoduls (100), umfassend einen ersten Schaltungsträger (102), der eines oder mehrere wärmeerzeugende Elemente (110) umfasst, die auf einer Oberseite des ersten Schaltungsträgers (102) montiert sind; einen zweiten Schaltungsträger (120), der über dem ersten Schaltungsträger (102) montiert ist und vertikal von der Oberseite des ersten Schaltungsträgers (102) beabstandet ist; einen oder mehrere Temperatursensoren (128), die fest mit dem zweiten Schaltungsträger (120) verbunden sind und in einem vertikalen Raum zwischen der Unterseite des zweiten Schaltungsträgers (120) und der Oberseite des ersten Schaltungsträgers (102) angeordnet sind; eine Mehrzahl von Elementen (114, 126), die sich von der Oberseite des ersten Schaltungsträgers (102) in Richtung des zweiten Schaltungsträgers (120) erstrecken und den zweiten Schaltungsträger (120) stützen; und dielektrisches Material (118), das einen Raum zwischen dem Temperatursensor (128) und dem ersten der wärmeerzeugenden Elemente (110) ausfüllt, wobei das dielektrische Material (118) eine Vergussmasse ist, die jedes der einen oder mehreren wärmeerzeugenden Elemente (110) einkapselt; und
Erhalten einer direkten Temperaturmessung eines ersten der wärmeerzeugenden Elemente (110) unter Verwendung eines ersten der Temperatursensoren (128).

11. Verfahren nach Anspruch 10, wobei das Halbleitermodul (100) einen Controller (122) umfasst, der auf einer Oberseite des zweiten Schaltungsträgers (120) montiert ist, und wobei das Verfahren ferner das Übertragen der direkten Temperaturmessung an den Controller (122) über eine Signalverbindung umfasst.

12. Verfahren nach Anspruch 11, wobei der erste Schaltungsträger (102) eine Mehrzahl der wärmeerzeugenden Elemente (110) umfasst, wobei der zweite Schaltungsträger (120) eine Mehrzahl der Temperatursensoren (128) umfasst, und wobei das Verfahren Erhalten einer direkten Temperaturmessung von jedem der wärmeerzeugenden Elemente (110) unter Verwendung jedes der Temperatursensoren (128) und sequentielle Lesen der direkten Temperaturmessungen im Controller (122) umfasst.

13. Verfahren nach einem der Ansprüche 10 bis 12, wobei das Erhalten der direkten Temperaturmessung eine Infrarotmessung umfasst.

## Revendications

1. Module (100) à semiconducteur, comprenant :
un premier support (102) de circuit comprenant un ou plusieurs éléments (110) produisant de la chaleur montés sur une surface supérieure du premier support (102) de circuit ;
un deuxième support (120) de circuit monté au-dessus du premier support (102) de circuit et étant à distance verticalement de la surface supérieure du premier support (102) de circuit ;
un capteur (128) de température, qui est fixé de manière fixe au deuxième support (120) de circuit et qui est disposé dans un espace vertical entre la surface inférieure du deuxième support (120) de circuit et la surface supérieure du premier support (102) de circuit ; et
une pluralité d'éléments (114, 126) s'étendant de la surface supérieure du premier support (102) de circuit vers le deuxième support (120) de circuit et supportant le deuxième support (120) de circuit,
dans lequel le capteur (128) de température est disposé suffisamment près d'un premier des éléments (110) produisant de la chaleur pour obtenir une mesure directe de la température du premier un des éléments (110) produisant de la chaleur, et
dans lequel le module (100) à semiconducteur comprend en outre un matériau (118) diélectrique, qui remplit un espace entre le capteur (128) de température et le premier un des éléments (110) produisant de la chaleur, dans lequel le matériau (118) diélectrique est un composé d'enrobage, qui enrobe chacun des ou plusieurs éléments (110) produisant de la chaleur.

2. Module (100) à semiconducteur suivant la revendication 1, dans lequel le capteur (128) de température est isolé galvaniquement du premier un des éléments (110) produisant de la chaleur.

3. Module (100) à semiconducteur suivant la revendication 1 ou 2, dans lequel
le premier un des éléments (110) produisant de la chaleur
est une puce à semiconducteur de puissance,
ou
le premier un des éléments (110) produisant de la chaleur est un élément passif.

4. Module (100) à semiconducteur suivant l'une quelconque des revendications 1 à 3, dans lequel le capteur (128) de température est monté directement sur le premier un des éléments (110) produisant de la chaleur.

5. Module (100) à semiconducteur suivant l'une quelconque des revendications 1 à 4, dans lequel le un ou les plusieurs éléments (110) produisant de la chaleur comprennent un deuxième un des éléments (110) produisant de la chaleur, dans lequel le capteur (128) de température est disposé latéralement entre le premier et le deuxième un des éléments (110) produisant de la chaleur, et dans lequel le capteur (128) de température est disposé suffisamment près du deuxième un des éléments (110) produisant de la chaleur pour obtenir une mesure de la température du deuxième un des éléments (110) produisant de la chaleur.

6. Module (100) à semiconducteur suivant l'une quelconque des revendications 1 à 5, comprenant en outre une unité (122) de commande montée sur une surface supérieure du deuxième support (120) de circuit, dans lequel l'unité (122) de commande est configurée pour recevoir un signal de mesure du capteur (128) de température et pour déterminer une température du premier un des éléments (110) produisant de la chaleur sur la base du signal de mesure.

7. Module (100) à semiconducteur suivant la revendication 6, dans lequel le module (100) à semiconducteur comprend une pluralité de capteurs (128) de température fixée de manière fixe au deuxième support (120) de circuit et disposés dans l'espace vertical entre la surface inférieure du deuxième support (120) de circuit et la surface supérieure du premier support (102) de circuit, dans lequel l'unité (122) de commande est configurée pour recevoir des signaux de chacun des capteurs (128) de température et pour déterminer une température d'au moins le premier un des éléments (110) produisant de la chaleur sur la base des signaux.

8. Module (100) à semiconducteur suivant la revendication 7, dans lequel le module (100) à semiconducteur comprend une pluralité d'éléments (110) produisant de la chaleur, dans lequel l'unité (122) de commande est configurée pour déterminer une température de chacun des éléments (110) produisant de la chaleur sur la base des signaux, et dans lequel les capteurs (128) de température de la pluralité dépassent en nombre tous les éléments (110) produisant de la chaleur montés sur le premier support (102) de circuit.

9. Module (100) suivant l'une quelconque des revendications 1 à 8, dans lequel au moins l'un
du premier support (102) de circuit est l'un quelconque : d'un substrat DCB, d'un substrat AMS, d'un substrat AMB ou d'un substrat IMS, et
le deuxième support (120) de circuit est une plaquette à circuit imprimé.

10. Procédé pour faire fonctionner un module (100) à semiconducteur, le procédé comprenant :
se procurer un module (100) à semiconducteur comprenant un premier support (102)
comprenant un ou plusieurs éléments (110) produisant de la chaleur montés sur une surface supérieure du premier support (102) de circuit ; un deuxième support (120) de circuit monté au-dessus du premier support (102) de circuit et étant à distance verticalement de la surface supérieure du premier support (102) de circuit ; un ou plusieurs capteurs (128) de température qui sont fixés de manière fixe au deuxième support (120) de circuit et disposés dans un espace vertical entre la surface inférieure du deuxième support (120) de circuit et la surface supérieure du premier support (102) de circuit ; une pluralité d'éléments (114, 126) s'étendant à partir de la surface supérieure du premier support (102) de circuit vers le deuxième support (120) de circuit et supportant le deuxième support (120) de circuit ; et un matériau (118) diélectrique, qui remplit un espace entre le capteur (128) de température et le premier un des éléments (110) produisant de la chaleur, dans lequel le matériau (118) diélectrique est un composé d'enrobage, qui enrobe chacun des un ou plusieurs éléments (110) produisant de la chaleur ; et
obtenir une mesure directe de température d'un premier un des éléments (110) produisant de la chaleur en utilisant un premier un des capteurs (128) de température.

11. Procédé suivant la revendication 10, dans lequel le module (100) à semiconducteur comprend une unité (122) de commande montée sur une surface supérieure du deuxième support (120) de circuit, et dans lequel le procédé comprend en outre transmettre la mesure directe de température à l'unité (122) de commande par l'intermédiaire d'une communication de signal.

12. Procédé suivant la revendication 11, dans lequel le premier support (102) de circuit comprend une pluralité d'éléments (110) produisant de la chaleur, dans lequel le deuxième support (120) de circuit comprend une pluralité de capteurs (128) de température, et dans lequel le procédé comprend obtenir une mesure directe de température de chacun des éléments (110) produisant de la chaleur en utilisant chacun des capteurs (128) de température et lire les mesures directes de température séquentiellement dans l'unité (122) de commande.

13. Procédé suivant l'une quelconque des revendications 10 à 12, dans lequel obtenir la mesure directe de température comprend une mesure en infrarouge.
